(19) Europäisches Patentamt
European Patent Office
Office européen des brevets

(11) **EP 2 235 394 B1**

(12) **EUROPEAN PATENT SPECIFICATION**

(45) Date of publication and mention
of the grant of the patent:
**03.12.2014 Bulletin 2014/49**

(51) Int Cl.:
*F16F 15/02* (2006.01) *F16F 15/03* (2006.01)

(21) Application number: **08867058.3**

(22) Date of filing: **31.12.2008**

(86) International application number:
**PCT/NL2008/050862**

(87) International publication number:
**WO 2009/084963 (09.07.2009 Gazette 2009/28)**

(54) **AN ACTIVE VIBRATION ISOLATION SYSTEM HAVING AN INERTIAL REFERENCE MASS**

SYSTEM ZUR ISOLIERUNG AKTIVER VIBRATIONEN MIT TRÄGER BEZUGSMASSE

SYSTÈME D'ISOLATION À VIBRATION ACTIVE AYANT UNE MASSE DE RÉFÉRENCE D'INERTIE

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **31.12.2007 EP 07124174**

(43) Date of publication of application:
**06.10.2010 Bulletin 2010/40**

(73) Proprietor: **Nederlandse Organisatie voor Toegepast -Natuurwetenschappelijk Onderzoek TNO 2628 VK Delft (NL)**

(72) Inventors:
• **KASTELIJN, Aukje**
  **NL-2628 VK Delft (NL)**
• **VAN DEN DOOL, Teun**
  **NL-2628 VK Delft (NL)**
• **FRAANJE, Rufus**
  **NL-2628 VK Delft (NL)**

• **ZULJAR, Robert**
  **NL-2628 VK Delft (NL)**

(74) Representative: **Marsman, Hermanus Antonius M. et al**
**V.O.**
**Johan de Wittlaan 7**
**2517 JR Den Haag (NL)**

(56) References cited:
**WO-A-2005/024266    WO-A-2005/073592**
**DE-U1- 29 612 349    US-A1- 2004 060 792**
**US-A1- 2005 018 160**

• **NELSON P G: "AN ACTIVE VIBRATION ISOLATION SYSTEM FOR INERTIAL REFERENCE AND PRECISION MEASUREMENT" REVIEW OF SCIENTIFIC INSTRUMENTS, AIP, MELVILLE, NY, US, vol. 62, no. 9, 1 September 1991 (1991-09-01), pages 2069-2075, XP000262841 ISSN: 0034-6748 cited in the application**

**Description**

The present invention relates to an active vibration isolation system with an inertial reference mass. More in particular, the present invention relates to an active vibration isolation system comprising a platform, an inertial reference mass, a support unit for supporting the reference mass without mechanical contact, a first sensor for supplying a signal that is representative for the distance between the reference mass and the platform, an actuator for displacing the platform with respect to a bearing body, a second sensor for supplying a signal that is representative for the distance between the platform and the bearing body, and a control unit for controlling the actuator.

A simple method to isolate a platform and the load on the platform from earth vibrations is by using mechanical springs, elastomers or magnetic bearings. However, at frequencies below the resonance frequency of the system consisting of the platform and the bearing, no isolation can be obtained with such a passive vibration isolation. The resonance frequency (f) is determined by the mass (m) of the platform and the stiffness (k) and the damping ratio ($\zeta$) of the bearing:

$$f = (2\pi)^{-1}\sqrt{(1 - \zeta^2)k/m}.$$

For increasing frequencies above the resonance frequency, the amplitude of the vibration of the platform will be lowered by a factor of 100 for each decade. To obtain a reduction from a 10 micrometer amplitude of the earth vibration to a 10 nanometre vibration amplitude of the platform at 1 Hz, the resonance frequency should be 0.032 Hz to obtain this reduction with a factor of 1000. In general, bearings have a stiffness that is no smaller than k = 1000 N/m. As a consequence, the mass of the platform must be at least 25,000 kg. Platforms with such a large mass are undesirable because of the special constructions that are needed to bear such a platform. Usually bearings have much higher stiffness than k = 1000 N/m resulting in the need for an even higher mass of the platform. In practice, the resonance frequency of passive systems is not lower than 2 Hz, which means that a reduction of the vibration amplitude by a factor of 1000 and more is obtained only at frequencies higher than 63 Hz. In principle bearings with resonance frequencies below 2 Hz may be possible, e.g. using configurations with several permanent magnets to compensate for the gravity force. In addition a Lorentz type voice-coil actuator may be used, e.g. to actively stabilize the system. However, platforms suspended at low resonance frequencies are also more sensitive (compliant) to disturbance forces other than those from ground vibrations, e.g. due to dynamical processes supported by the platform.

Active control on the basis of a measurement of the vibration allows a better isolation from undesired vibrations without increasing the compliance as in (passive or active) isolation techniques that only adjust the stiffness coupling between the source of the vibration, e.g. the floor, and the platform. The principle of this active vibration control is well described in literature, see e.g. P.R. Saulson, "Vibration isolation for broadband gravitational wave antennas", Rev. Sci. Instrum. 55(8), August 1984, pp.1315-1320 and P.G. Nelson, "An active vibration isolation system for inertial reference and precision measurement", Rev. Sci. Instrum. 62 (9), September 1991, pp.2069-2075. A sensor set-up capable of detecting the undesired vibration can be placed either on the source of the vibration or on the platform that has to be isolated from earth vibrations or other mechanical disturbances. The platform is supported by springs or other bearings and it can be driven by an actuator like a servomotor along the sensitive axis of the sensor. The electronic output of the sensor is (filtered and) fed back to the actuator that compensates for the undesired vibration. As a further improvement of vibration isolation more than one sensor can be used. International Patent Application WO 2005/024266 A1 discloses in particular the use of two sensors, one for measuring the displacement of the platform with respect to the reference mass and the second one for measuring the displacement of the platform relative to the earth or floor on which the platform is placed.

The sensor set-up capable of detecting the undesired vibration typically comprises a reference mass that is small in comparison to the mass of the platform, and the actual sensor measuring the vibration for instance by optical or electrical means. The reference mass is supported by a spring that has sufficiently high stiffness to compensate for the gravitational force on the mass. To obtain a resonance frequency of 0.1 Hz for a typical reference mass of 0.1 kg, the stiffness of a mechanical spring needs to be 0.04 N/m. For such a low stiffness, gravity force would result in an elongation of the spring of more than 25 meters. Special type of springs (such as constant force springs) may be used to achieve a lower stiffness without significant elongation. However, compact supports with resonance frequencies well below the 1 Hz are difficult to achieve by using mechanical springs.

The vibration of the reference mass with respect to the platform is detected mechanically, electrically, optically or electro-magnetically. For this purpose the sensor comprises a commonly known mean for detecting acceleration, velocity or distance.

It is well known that for the feedback of the signal supplied by the displacement sensor to the actuator, common PID control can be used. Noise, parasitic effects and actuator nonlinearities, however, prevent effective vibration isolation below 0.5 Hz in practise. The best performance claimed until now seems to be a resonance frequency of 0.2 Hz in a system where the actuator and the sensor are located substantially close to each other as disclosed in the US patent 6808051 B2.

Earth vibrations and other mechanical disturbances are becoming more and more a limiting factor for applications that demand an environment that is free of such disturbing vibrations. Space equipment under development on earth, demands a test environment that is similar to the working environment in space. The further decreasing dimensions as foreseen for semiconductor products like processors and memories, demand a better stability of the lithographic equipment that is used for the fabrication of these products than is available at present. Low frequency vibrations are preventing further improvement of the resolution of electron and atomic force microscopes.

It is well known that a Lorentz or voice-coil type of geometry consisting of a permanent magnet and a coil can be used for bearing and displacing a platform, see e.g. International Patent Application WO2004/029475 A1. However, due to the large mass of a platform, considerable amount of energy (electrical power) is needed to elevate the platform permanently. Because a significant part of the energy is transferred into heat, special precautions have to be taken to shield load on the platform from the heat generated by the bearing.

The performance of the currently available vibration isolation platforms and other platforms for the isolation of vibrations do not meet the requirements asked for in the near future. In particular for low frequencies, e.g. in the band of 0.01-10 Hz, vibrations cannot be isolated sufficiently to reduce the amplitude of the vibrations of the bodies to be isolated, to a level well below 10 nanometres.

It is therefore an object of the present invention to overcome these and other problems of the Prior Art and to provide an active vibration isolation system having improved properties. More in particular, it is an object of the present invention to provide a better vibration isolation of platforms and other equipment at low frequencies, in particular but not limited to frequencies in the band of 0.01-10 Hz.

Accordingly, the present invention provides an active vibration isolation system comprising a platform, an inertial reference mass, a support unit for supporting the reference mass without mechanical contact, a first sensor for supplying a signal that is representative for the distance between the reference mass and the platform, an actuator for displacing the platform with respect to a bearing body, a second sensor for supplying a signal that is representative for the distance between the platform and the bearing body, and a control unit for controlling the actuator, which system is characterised in that the first sensor is a displacement sensor and that the reference mass is connected with a low stiffness to the platform via the support unit that is supported by the platform. The system is further characterised by that the control unit is arranged for receiving a signal from the first sensor and the second sensor and is arranged for providing a signal to a support unit and the actuator.

By providing a support unit which is, in turn, supported by the platform on which the load can be placed, a more direct coupling between the undesired vibration of the platform and the actuator displacing the platform is obtained which results in an improved vibration isolation.

The present invention is in particular suited for platforms that are used to support instruments under test, e.g. instruments for space applications. However, the present invention can also be used for vibration isolation in a large variety of equipment, including but not limited to telescopes, lithographic machineries and cars. So in general, the platform can be placed on any type of bearing body, either the floor or any other base. Hereby it is acknowledged that such a base might be mechanically connected to earth but need not to be.

In the system according to the present invention, the support unit preferably comprises a Lorentz type of geometry supporting the reference mass. Alternatively, the support unit may comprise electromagnetic, electro-static, magneto-static or other mains for supporting the reference mass without mechanical contact between the reference mass and the platform.

The distance between the reference mass and the platform may be measured by optical, electrical, or electro-magnetic means. Advantageously, the actuator may comprise a Lorentz type of geometry. The control unit preferably receives an absolute feed-back signal from the said first sensor.

The present invention will further be explained below with reference to exemplary embodiments illustrated in the accompanying drawings, in which:

Figure 1 schematically shows an active vibration isolation system according to the state of the art.
Figure 2 schematically shows an active vibration isolation system according to the present invention.
Figure 3 schematically shows an active vibration isolation system according to the present invention in which two separate controllers are used to control the actuator 3 and the support unit 10.
Figure 4 schematically shows an embodiment of a reference mass, a displacement sensor, and a support unit which may be used in the system of Figure 2 and Figure 3.
Figure 5 graphically shows the vibration transfer from a vibrating base to a platform without active control.
Figure 6 graphically shows the level of the vibration of the base and the level of the vibration of a platform without active control.

Figure 7 schematically shows an embodiment of a controller setup as may advantageously be used in the present invention.

Figure 8 schematically shows another embodiment based on the one shown in Figure 7, including inversion of the voice coil nonlinearity as may be advantageously be used in the present invention.

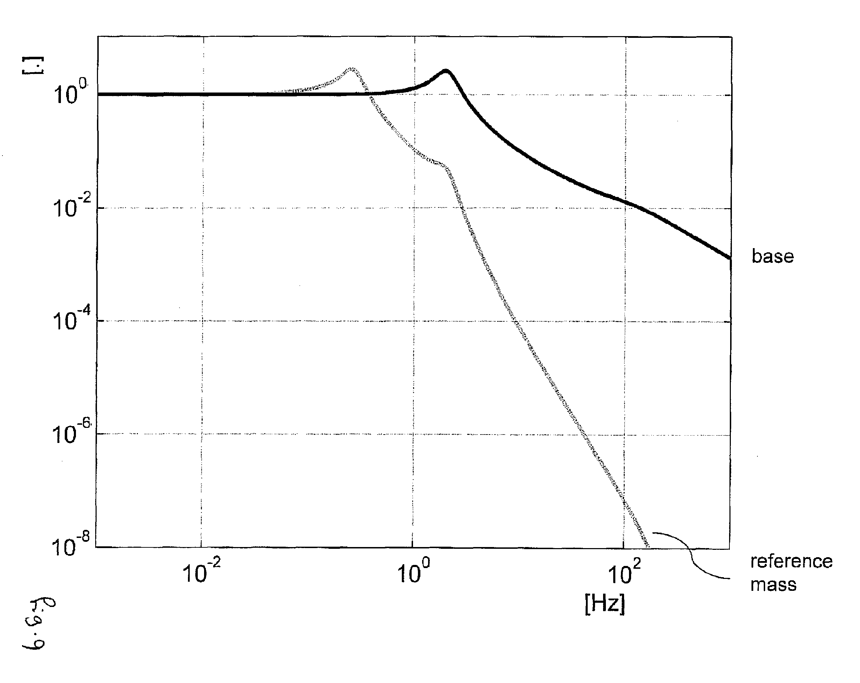

Figure 9 graphically shows the transfer from the base to the platform and from the base to the reference mass in a sensor system, for the case without feedback of the sensor system signal to the actuator between the base and the platform.

Figure 10 graphically shows the magnitude of the loop gain between the actuator located between the base and the platform on the one hand and the output of the sensor system on the other hand, i.e., the relative distance between the reference mass and the platform.

Figure 11 graphically shows the phase corresponding to the gain depicted in Figure 10.

Figure 12 graphically shows the transfer from the base to the platform, without and with control including feedback from the sensor system.

Figure 13 shows the level of vibration of the uncontrolled platform (solid line), the controlled platform (dotted marked with x) and the influence of other disturbance forces on the base (grey marked with o) and amplifier noise in the sensor system (dotted marked with +).

Figure 14 shows the same quantities as Figure 13 that are obtained using an additional feedback from the relative position of the table with respect to the base to the actuator of a sensor system.

The vibration isolation system of the invention comprises an inertial reference mass. Because of the fact that this mass is very softly connected to the platform that has to be isolated (with nearly zero, positive stiffness), this mass is considered to be an absolute reference for the position of the platform. Such a nearly zero stiffness cannot be obtained by conventional means like mechanical springs, as used in Saulson (1984), Nelson (1991), and WO2004/029475 unless allowing for large system dimensions (above several metres). Another disadvantage is (hysteretic) damping which increases the vibration sensitivity above the resonance frequency such that the sensitivity does not roll-off with a factor proportional with the squared frequency but will roll-off linearly with the frequency.

A Lorentz type of geometry, comprising a coil and a magnet, allows a zero stiffness operation while exerting a force to compensate for gravity. Due to spatial inhomogeneity of the magnetic field, the stiffness is zero in just a single point and increases or decreases away from this point. Using feedback from the position of the inertial reference mass relative to the platform, i.e. the distance between the coil and the magnet, the stiffness can be set to a low positive value to prevent drifting and to guarantee a resonance frequency significantly below 1 Hz. In contrast to vibration isolation systems where the whole platform is borne by such a support unit, in the system according to the invention only the low-weight reference mass is borne by the support unit. As a consequence the support unit can be small and the energy consumption (and possible heating) low. Typically the reference mass will be lower than 1 kg, preferably even below 0.1 kg.

In the system according to the invention there is no need for special bearing for the platform; the common bearings can be used for supporting the platform without influencing the high level of vibration isolation. The functioning of such a bearing might, among others, be based on pneumatic or magnetic levitation or the bearing might be constructed using an elastomeric material or a mechanical spring. The same holds for the actuator; common available servo-motors and piezo-electric motors can be used. The reason that there are no specific demands is that the stiffness of both bearing and actuator is compensated by a properly designed electronic control system. In principle also a Lorentz actuator can be used for bearing the load. However, the disadvantage is that a Lorentz actuator needs an electrical current to apply a force. In particular for heavy platforms the current will result in significant heating of the actuator and its environment. For sensitive applications, cooling will be needed to transport the heat.

In the present invention an absolute position feedback is used by means of a sensor system mounted on the platform to obtain the high accuracy needed for the high level of vibration isolation at low frequencies. The sensor is mounted on the table rather than the disturbance source, because the susceptibility of the sensor's reference mass for the disturbing vibrations will be even more reduced when the vibrations of the platform are suppressed. It is important that the relative position between the reference mass and the platform (viz. the approximately absolute position of the platform), as provided by the sensor system, is fed back rather than, e.g., the relative velocity as in WO 2004/029475, or acceleration, to actively suppress the vibration of the platform. Feeding back the velocity and acceleration will provide suppression of vibrations especially at the high frequencies (above the resonance frequency coupling between the platform and the vibrating source), at the expense of less suppression in the lower frequency band. To suppress the vibrations in the lower frequency band, one may integrate the velocity or doubly integrate the acceleration (e.g., Saulson 1984). However the use of an accurate displacement sensor, as in the present invention, is highly preferred to prevent the amplification of measurement and electronic (such as 1/f) noise at low frequencies.

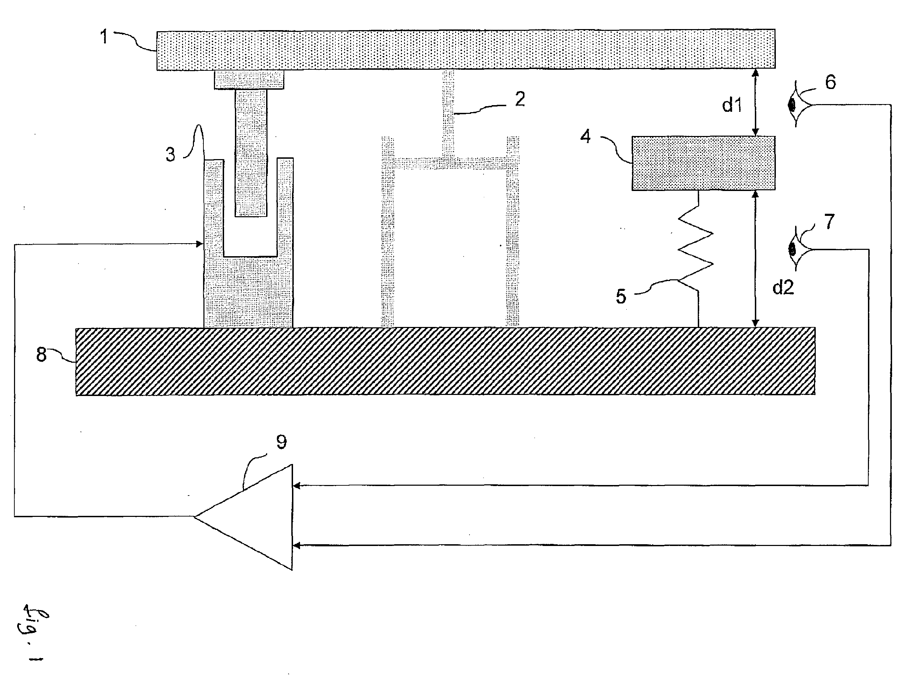

Figure 1 shows an active vibration system according to the state of the art. The platform 1 that is supported by a platform bearing 2 can be moved by an actuator 3. The reference mass 4 is supported by a reference mass bearing 5, whereas a first sensor 6 provides a signal that is representative for the distance d1 between the platform 1 and the reference mass 4 and a second sensor 7 provides a signal that is representative for the distance d2 between the reference mass 4 and the floor 8. The controller 9 is provided with the output signal of the first sensor 6 and the output signal of the second sensor 7 and the controller itself provides the actuator 3 with an input signal to move the platform 1. It will be understood that the platform 1 is suitable for accommodating a load, for example a precision instrument.

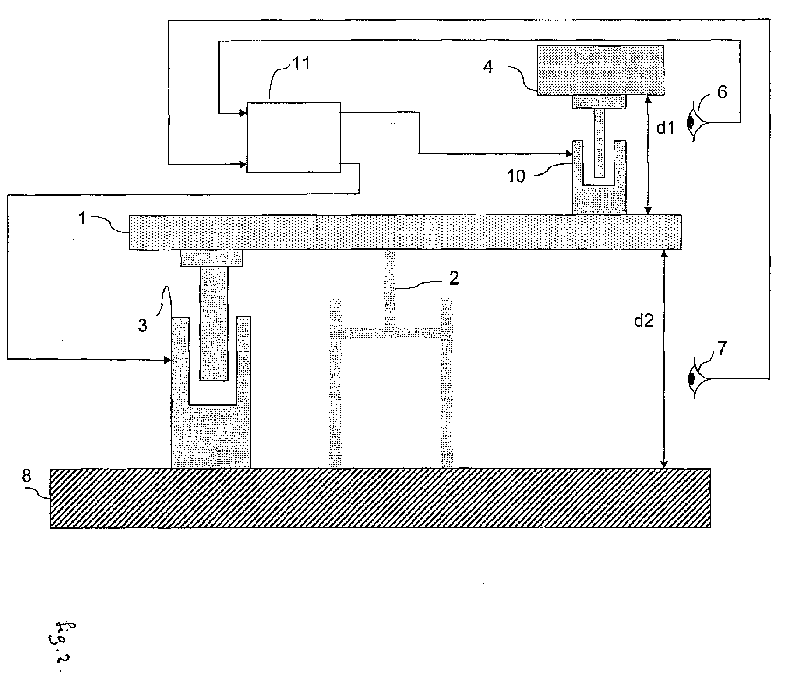

Figure 2 shows schematically an embodiment of the system according to the invention. The embodiment shown merely by way of non-limiting example in Figure 2 comprises a platform 1, a bearing 2, an actuator 3, a reference mass 4, a first sensor 6 and a second sensor 7. The system further comprises a control unit 11 for controlling the actuator 3 and the position of the reference mass supported by the support unit 10.

The platform 1 that is supported by a platform bearing 2 can be moved by an actuator 3. Although the platform bearing 2 and the actuator 3 might be two separate components, the functions of these two elements can be combined into one element like a Lorentz actuator. The reference mass 4 is supported by a support unit 10 that is designed in such a way that there is no mechanical contact between the mass and the platform.

The system according to the invention also comprises a first sensor 6 providing a signal that is representative of the absolute distance d1 between the platform 1 and the reference mass 4, and a second sensor 7 providing a signal that is representative of the distance d2 between the platform 1 and the floor 8. The second sensor does not necessarily have to meet specific demands. It might be a velocity sensor or an acceleration sensor measuring the relative distance or a sensor that measures the absolute distance. Of course the floor can also be any other construction supporting the platform bearing and the actuator whether or not this construction is fixed to earth.

In accordance with the present invention, the support unit 10 is supported by the platform 1. In the preferred embodiment the support unit is placed or mounted on the platform. In another embodiment of the system according to the invention, the support unit 10 is fixed to the platform 1. The controller 11 is provided with the output signal of the first sensor 6 and the output signal of the second sensor 7 and the controller 11 itself provides the actuator 3 and the support unit 10 with an input signal to move the platform 1 and the reference mass 4, respectively. Typically, the controller 11 might be a multichannel controller.

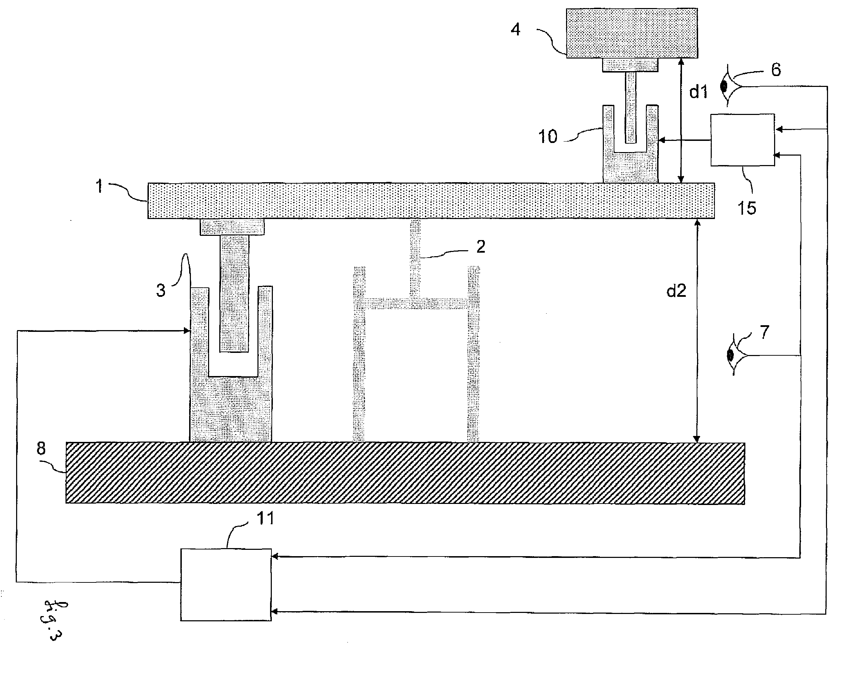

Figure 3 shows schematically another embodiment of the systems according to the invention. This embodiment comprises a further control unit 15 for controlling the support unit (10), in particular for controlling the position of the reference mass 4. It might be advantageous to use separate control units for the actuator 3 and the support unit 10. In this embodiment, the further control unit 15 is connected to the first control unit 11 to receive and send signals to this first control unit.

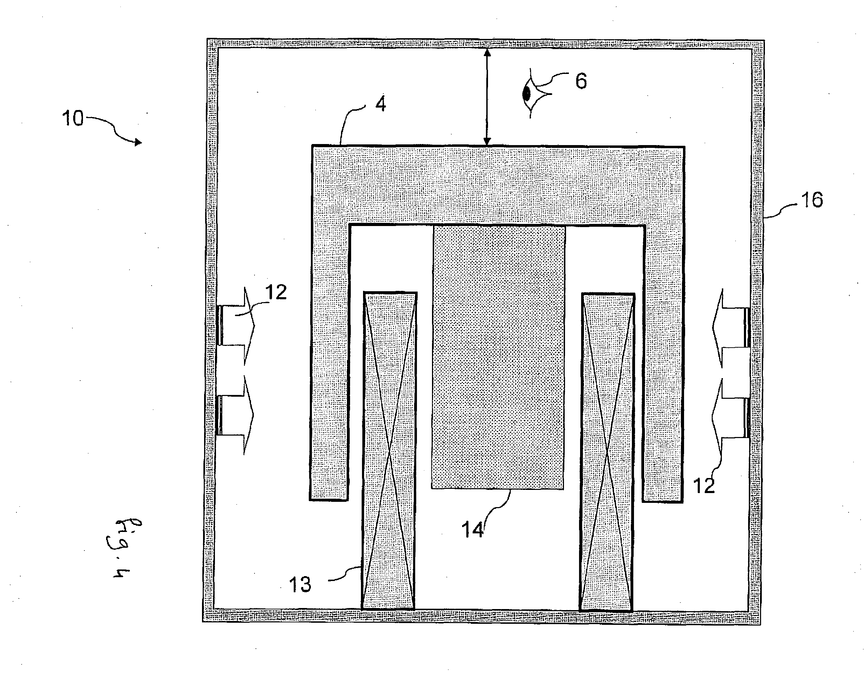

Figure 4 shows a preferred embodiment of a Lorentz type of support unit 10, the reference mass 4 and the sensor 6 with one degree of freedom. The sensor may be an optical interferometer, a capacitor or any other sensing element that can measure the distance between the reference mass 4 and the platform 1 or the housing 16 of the support unit 10 placed or mounted on the platform or fixed to it. The sensor, however, should be contactless, to prevent coupling of vibrations to the reference mass 4. In the embodiment shown in figure 4, the support unit 10 comprises a coil 13 in which a permanent magnet 14 is situated. The permanent magnet 14 is fixed to the reference mass 4. In this particular embodiment a movement in one of the other degrees of freedom is prevented by an air bearing 12. It is understood that it is also possible to fix the coil to the reference mass and the magnet to the housing. The reference mass may also be supported without making mechanical contacts by other means, such as particular configurations with several magnets, by means of an electrostatic force or by a combination of such means.

To illustrate the present invention, consider a platform of mp=30 kg, which is suspended by a (passive) bearing with stiffness of $k_p$=50·10³ N/m with a damping ratio of 10% such that the damping will be $d_p$=245 kg/s. Then the transfer function from the base vibrations, represented by $z_b$, to the platform, represented by $z_p$, is given by

$$z_p = \frac{d_p s + k_p}{m_p s^2 + d_p s + k_p} z_b$$

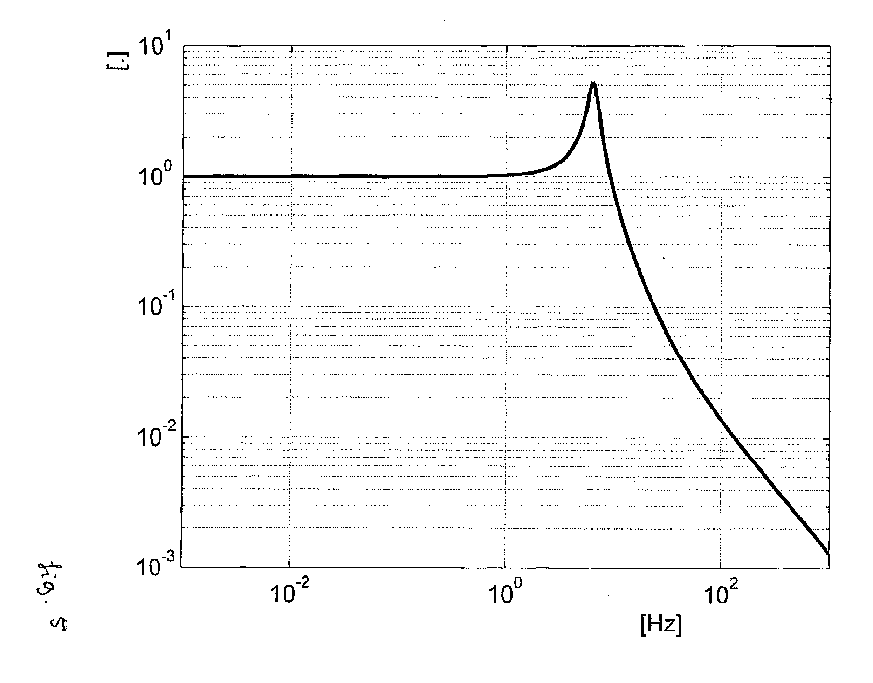

where s the Laplace operator. This transfer function is depicted in Figure 5.

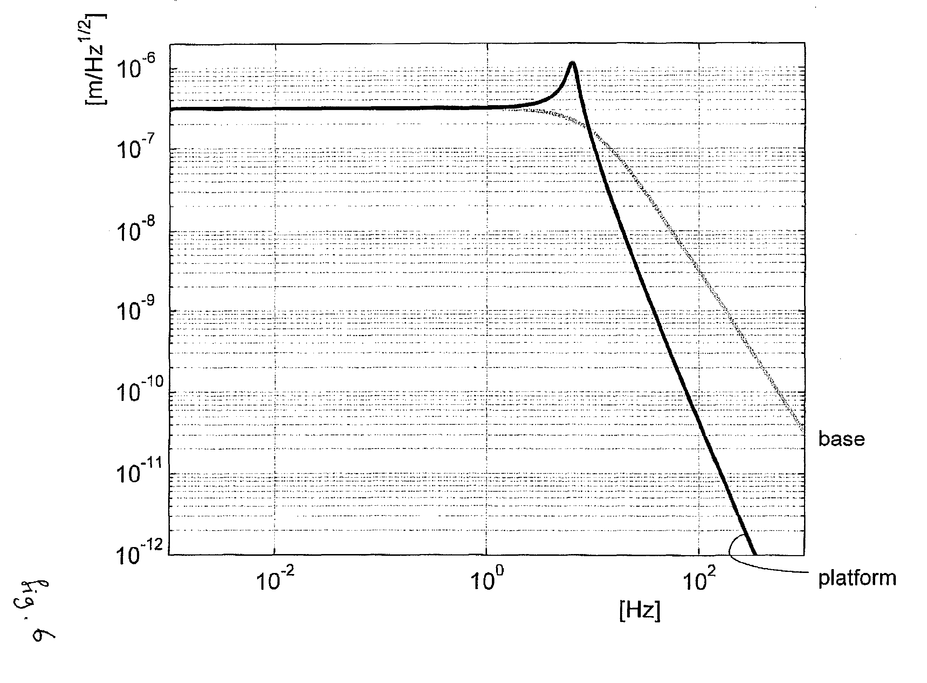

Figure 6 shows the level of vibration of the base, which is assumed to have a root-mean-square (RMS) value of 1 $\mu$m over a bandwidth of 10 Hz. The resulting level of the platform is also depicted in Figure 6. When a voice coil actuator 3 is used to actuate a force between the base and the platform the actuator force $F_{p \cdot a}$ can be approximately described by

$$F_{p,a} = K_{p,o}(1 + \gamma_p(z_p - z_b - z_{p,o})^2)K_i V_p$$

where $V_p$ the voltage output of the controller, $K_i$ the gain of the voltage to current amplifier to drive the current through the coil. $K_{p,o}$ is the nominal motor constant of the voice coil and $\gamma_p$ a parameter that determines the stiffness variation of the voice coil and $z_{p,o}$ the zero-stiffness position. Optionally, the position-dependent gain

$$K_{p,o}\left(1 + \gamma_p(z_p - z_b - z_{p,o})^2\right)$$

of the voice coil actuator can be approximated by a more complex structure, such as a higher order polynomial, a rational function, a neural network, a spline approximation or table lookup. The coefficients of the interpolating functions can be determined on the basis of measured data using standard algorithms, such as (nonlinear) least squares or root finding methods. In the present example of the invention, a Bei Kimco LA 10-12-027A voice coil has been used with $K_{p,o}$ = 5.8 N/A and $\gamma_p$ = -4.5 · $10^3$/m$^2$ and $z_{p,o}$=1.6 mm, which depends on the precise alignment of the displacement sensor 7 which measures the displacement

$$z_{p,m} = z_p - z_b + z_{p,n}$$

where $z_{p,n}$ is the measurement noise (using accurate capacitive sensors, or interferometers, the measurement noise level may be below $1 \cdot 10^{-9}/\sqrt{5000}\mathrm{m}/\mathrm{Hz}^{1/2}$ over a bandwidth of 5000 Hz).

The sensor system is mounted on top of the platform. The inertial reference mass with mass $m_s$=0.160 kg is lifted up using voice coil actuator, which supplies a force

$$F_{s,a} = K_{s,o}\left(1 + \gamma_s(z_s - z_p - z_{s,o})^2\right)i_s$$

where $K_{s,o}$=$K_{p,o}$, $\gamma_s = \gamma_p$ and e.g. $z_{s,o}$=1 mm depending on the alignment of the displacement sensor. The current consists of two terms:

$$i_s = i_{s,o} + K_{s,i}V_s$$

where $i_{s,o}$ a DC term to generate a DC force counteracting the gravity force which can be supplied by a separate stable DC current source. The other term $K_{s,i}V_s$ contains the transfer of the voltage to the current converter, e.g., $K_{s,i}$=0.001A/V, and the control voltage $V_s$ supplied by the controller.

When the gravity forces are counteracted by the platform bearing and the reference mass by the DC current $i_{s,o}$ through the coil of voice coil actuator 3, the position of the platform and the sensor mass are determined by the following coupled differential equations:

$$m_s s^2 z_s = (d_s s + k_s)(z_p - z_s) + K_{s,o}\left(1 + \gamma_s(z_s - z_p - z_{s,o})^2\right)K_{s,i}V_s$$

$$m_p s^2 z_p = (d_p s + k_p)(z_b - z_p) - (d_s s + k_s)(z_p - z_s) + F_{p,n} + \\ + K_{p,o}\left(1 + \gamma_p(z_p - z_b - z_{p,o})^2\right)K_{p,i}V_p$$

where the term $F_{p,n}$ represents other disturbance forces that act on the platform, i.e. due to moving instruments on the platform as is common in lithography applications. The reference mass is isolated sufficiently from acoustic disturbances and other forces (e.g., by using a vacuum chamber) such that the disturbance forces on the inertial reference mass $m_s$ can be neglected. Because the reference mass is not supported by a passive bearing, we may set $k_s$=0 N/m and $d_s$=0 kg/s.

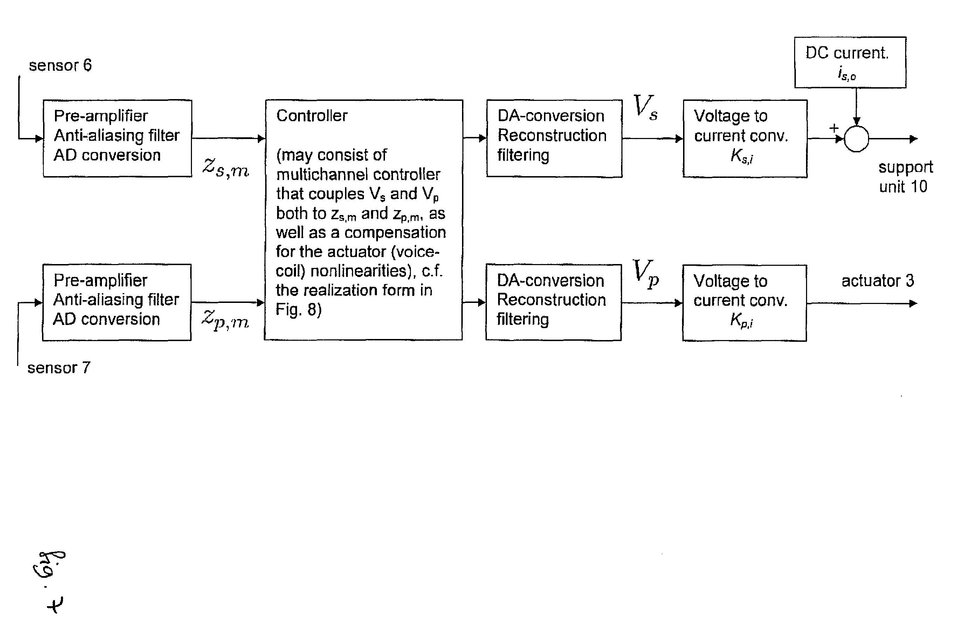

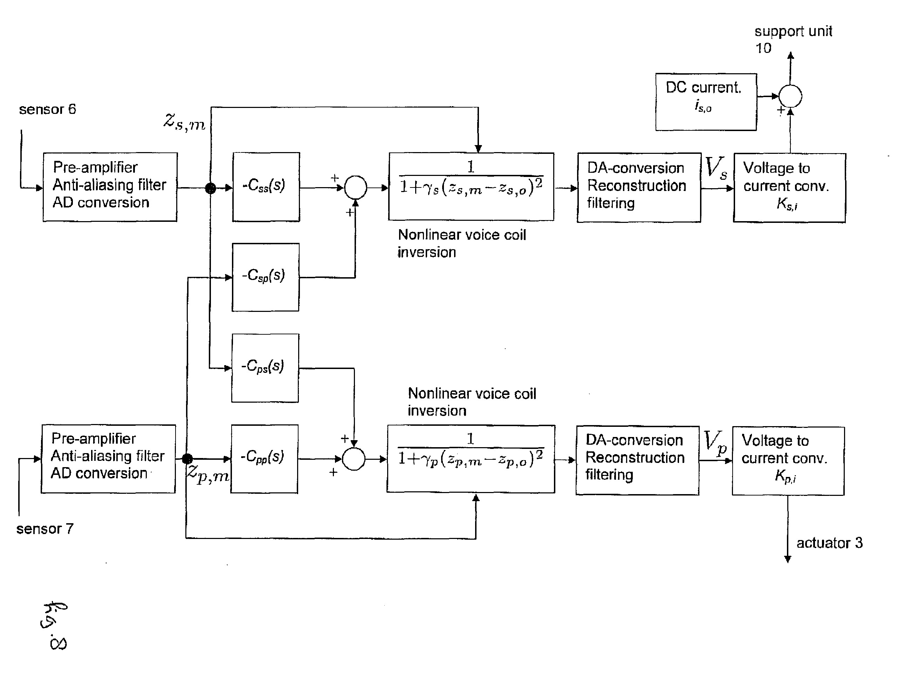

A preferred controller setup is depicted in Figure 7 and described in more detail in Figure 8. The inputs to the controller are the displacement sensor 6 that measures the relative distance between the reference mass and the platform, $z_{s,m} = z_s - z_p + z_{s,n}$, where $z_{s,n}$ the measurement noise which is of the same level as the measurement noise on the measurement supplied by sensor 7 , that represents the distance between the platform and the base, $z_{p,m} = z_p - z_b + z_{p,n}$. These relative positions are the inputs of four linear dynamic controllers that are described below, and also used in the compensation of the voice coils stiffness dependency of the relative positions. When the compensation is perfectly done, the dynamics of the whole system can be described by linear differential equations. Now, the controllers could be designed using optimal $H_2$, LQG, or $H_\infty$ optimal control. One may use particular frequency dependent weighting functions for the optimization in a particular frequency band, e.g. 0.01-10 Hz, but these functions increase the complexity of the controller and it may be rather cumbersome to design the weighting filters. Moreover, such methods are based on the availability of very accurate parametric models of the system.

Although the methods mentioned above, can be applied within the present invention, another method is preferred. This preferred method uses tuning rules to determine the controller parameters which are based on the insight in the relation between the controllers and the achieved vibration suppression and compliance behaviour.

The controllers $C_{ss}$ and $C_{pp}$ are adjusting the stiffness and damping characteristics between the platform and the inertial reference mass and between the base and the platform respectively. This can be seen directly from the dynamics of the controlled system by setting the (cross)controllers $C_{sp}$ and $C_{ps}$ to zero, and assuming that the nonlinearity is perfectly compensated, which yields the following transfer from $z_b$ to $z_s$ and $z_p$ in the Laplace domain:

$$\begin{bmatrix} z_s \\ z_p \end{bmatrix} = \left( \left( m_s s^2 + K_{s,o} K_{s,i} C_{s,s} \right) \left( m_p s^2 + d_p s + k_p + K_{p,o} K_{p,i} C_{p,p} \right) \right)^{-1} \times$$

$$\begin{bmatrix} K_{s,o} K_{s,i} C_{s,s} \left( d_p s + k_p + K_{p,o} K_{p,i} C_{p,p} \right) \\ \left( m_s s^2 + K_{s,o} K_{s,i} C_{s,s} \right) \left( d_p s + k_p + K_{p,o} K_{p,i} C_{p,p} \right) \end{bmatrix} z_b$$

From this expression we observe that $C_{s,s}$ determines the resonance frequency and damping of the sensor system relative to the platform and $C_{p,p}$ the resonance frequency and damping of the platform relative to the base. $C_{s,s}$ is designed such that some stiffness is added to prevent the reference mass from drifting. The resonance frequency of the reference mass is set to 0.1 Hz and at this frequency a phase-lead of 30° has been added to increase the damping around this resonance frequency by means of a lead compensator

$$C_{s,s} = \frac{15.0s + 5.44}{s + 1.088}$$

On the other hand $C_{p,p}$ is designed to reduce the stiffness $k_p$ and the damping dp, and thus to lower the resonance frequency of the platform. Selecting

$$C_{p,p} = -\frac{288.8s + 7.759 \cdot 10^4}{1 \cdot 10^{-6} s^2 + 0.002s + 1}$$

introduces a negative stiffness and damping together with two poles at 1000 rad/s to obtain sufficient roll-off at high frequencies. In this way the resonance frequency of the base-platform connection is shifted from 6.4 Hz to 2.6 Hz.

Although the controller $C_{p,p}$ reduces the stiffness of the coupling between the base 8 and the platform 1, it appears to be rather difficult in practice to significantly reduce the stiffness such that a resonance frequency below 1Hz will been obtained. Moreover, reducing the stiffness also increases the compliance of the platform, i.e., its sensitivity with respect to disturbance forces, which is undesirable.

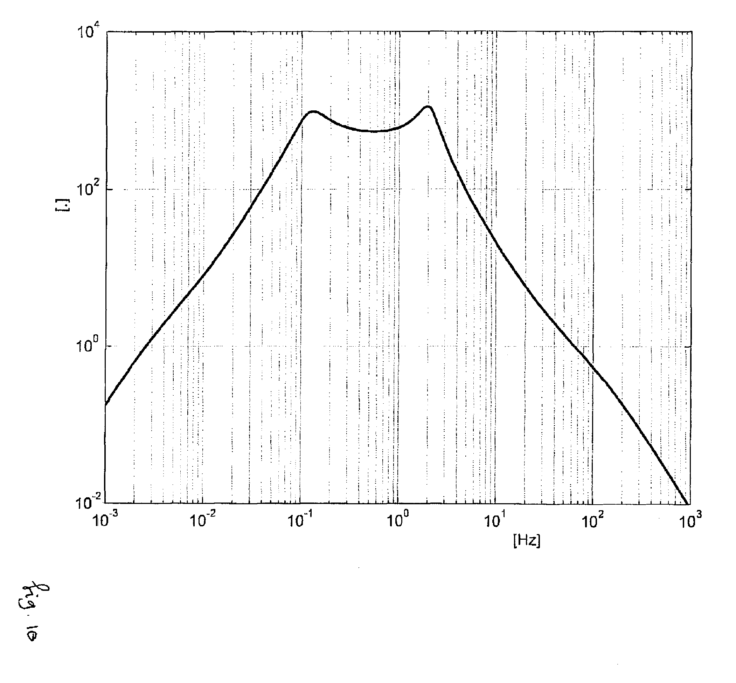

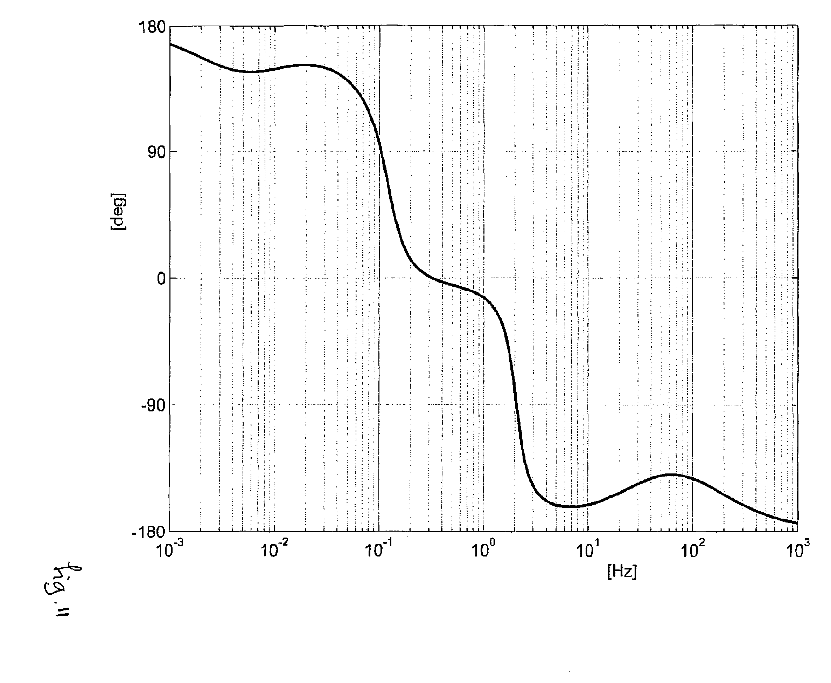

For this reason feedback from the inertial sensor has been used, which involves the tuning of controller $C_{p,s}$. Using simple lead- and lag-networks the loop-gain of the feedback loop including the position from the reference mass 6 and the platform actuator 3 can be tuned such that the gain and phase are obtained as depicted in Figure 10 and Figure 11 respectively. The resulting controller $C_{p,s}$ is given by

$$C_{p,s} = -10^7 \frac{1.8s^2 + 350s + 19}{s^2 + 876s + 15.9}$$

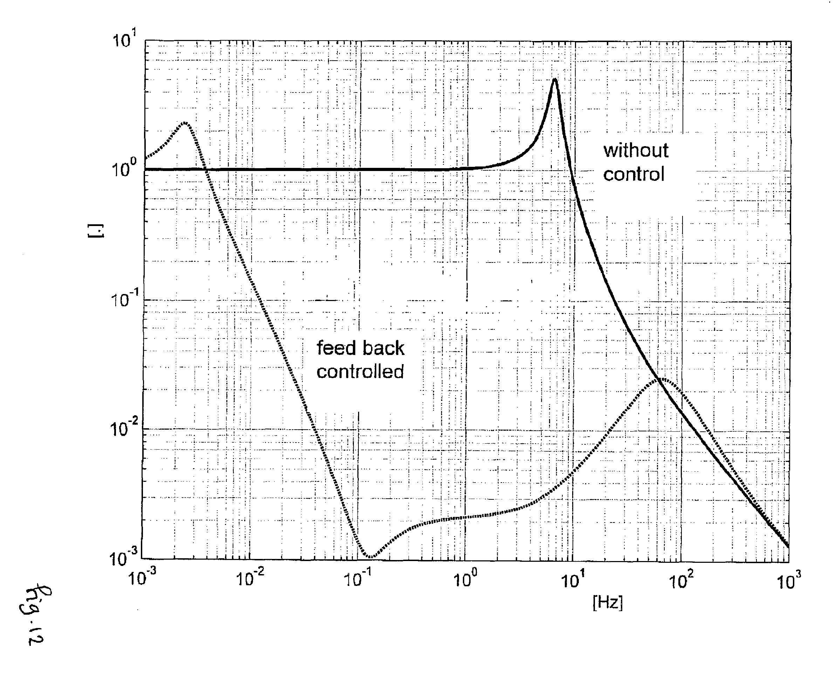

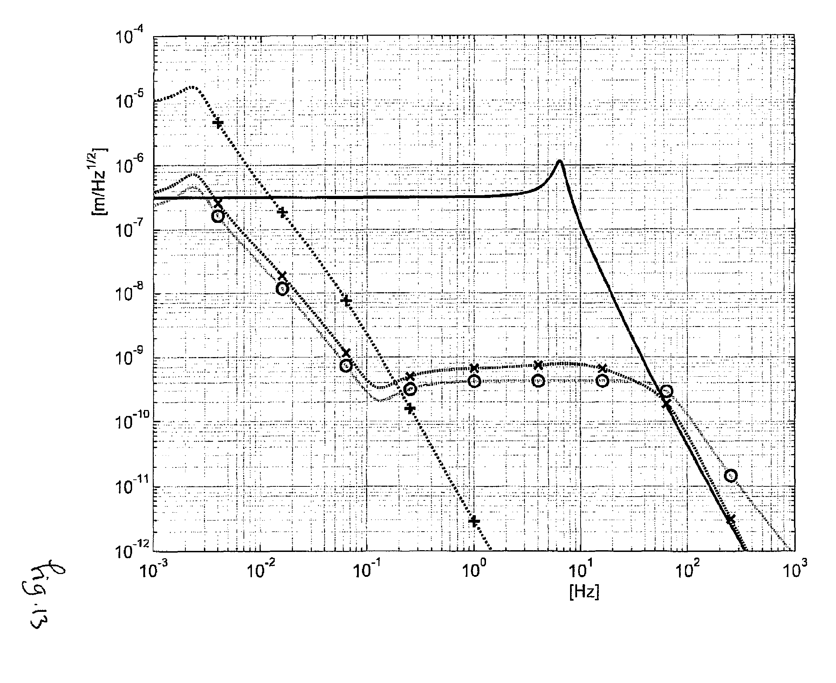

The resulting transmission of ground vibrations is depicted by the dotted curve in Figure 12, where the solid curve shows the transmission when the controller $C_{p,s}$ is turned off. Figure 13 shows the same curves as Figure 12 but also includes the contribution to disturbance forces on the platform with a density of $1mN/Hz^{1/2}$ (grey marked with o's) and noise on the amplifier to control the bearing 10 for the reference mass, which has a density of $0.9nV/Hz^{1/2}$ and a 1/f noise from 20Hz and below, comparable with the Analogue Devices AD797 operational amplifier. From Figure 13 it can be observed, that at low frequencies (below 0.2Hz) the noise of the amplifier is dominant over the ground vibrations. To reduce the sensitivity with regard to this disturbance it would be possible to use the final feedback loop which consists of a measurement of the position of the platform relative to the base, 7, and actuates the force between the platform and the reference mass by means of the bearing 10. Here we selected the controller $C_{sp}$ to be a lead filter with 45° phase lead at 10mHz.:

$$C_{ps} = \frac{1.92s + 0.05}{6.6s + 1}$$

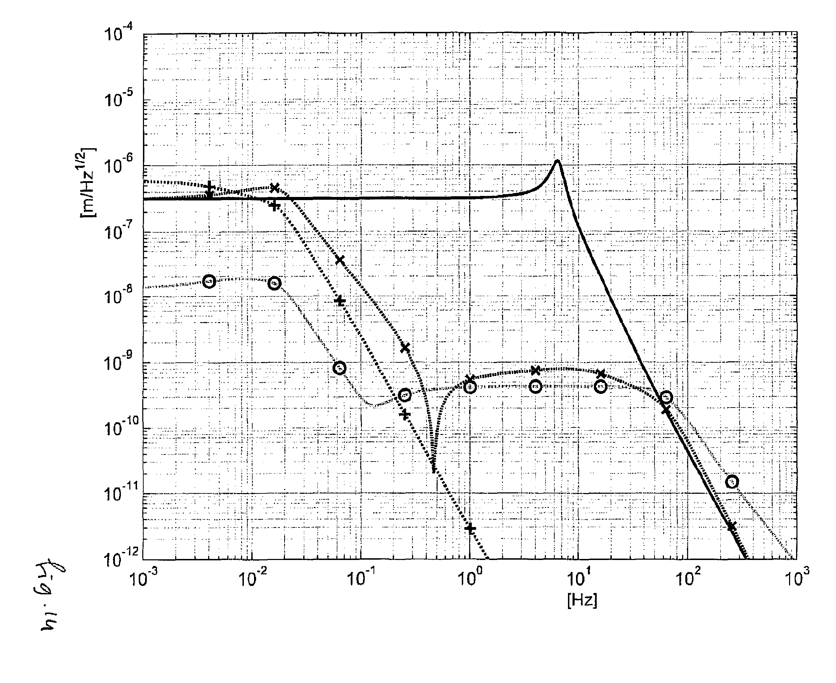

Using this controller, the contribution of disturbance forces as well as the amplifier noise in the sensor system is suppressed, at the expense of some isolation w.r.t. vibrations from the base, as is depicted in Figure 14.

An embodiment has been described above for one degree of freedom but persons skilled in the art can easily incorporate the principles for all six degrees of freedom.

The present invention is based upon the insight that a further improvement of present active vibration isolation systems is possible without increasing the compliance when using an inertial reference mass placed on, or at least attached to, the platform in combination with a control system that comprises both a feedback from the displacement of the platform relative to the inertial reference mass and a feedback from the displacement of the platform relative to the source of the vibration.

It is noted that any terms used in this document should not be construed so as to limit the scope of the present invention. In particular, the words "comprise(s)" and "comprising" are not meant to exclude any elements not specifically stated. Single (circuit) elements may be substituted with multiple (circuit) elements or with their equivalents. Neither should electrical connections or signal transfers be interpreted as being limited to wiring. In the appropriate case, connections and signal transfer can be wireless, either by radio signals, infrared or other mains of wireless communication and transfer.

The present invention not only relates to protecting the isolated equipment from vibrations originating from its environment but also to protecting the environment from the vibrations originating from the equipment that is isolated.

It will therefore be understood by those skilled in the art that the present invention is not limited to the embodiments illustrated above and that many modifications and additions may be made without departing from the scope of the invention as defined in the appending claims.

**Claims**

1. An active vibration isolation system comprising a platform (1), an inertial reference mass (4), a support unit (10) for supporting the reference mass (4) without mechanical contact, a first sensor (6) for supplying a signal that is representative of the distance (dl) between the reference mass (4) and the platform (1), an actuator (3) for displacing the platform (1) with respect to a bearing body (8), a second sensor (7) for supplying a signal that is representative of the distance (dl) between the platform (1) and the bearing body (8), and a control unit (11) for controlling the actuator (3), - the first sensor (6) being a displacement sensor; **characterised in that**

   - the control unit (11) is arranged for receiving an absolute feedback signal from the first sensor (6) and the second sensor (7) and is arranged for providing a signal to the support unit (10) and the actuator (3),
   - and that the reference mass (4) is connected with a low, nearly zero stiffness to the platform (1) via the support unit (10) that is supported by the platform (1).

2. The system according to claim 1, in which the support unit (10) comprises a Lorentz type of geometry supporting the reference mass (4).

3. The system according to claim 1, in which the support unit (10) comprises electromagnetic, electro-static or magneto-static mains for supporting the reference mass (4).

4. The system according to any of the preceding claims, in which the distance (dl) between reference mass and the platform is measured by optical, electrical, or electro-magnetic means.

5. The system according to any of the preceding claims, in which the actuator (3) comprises a Lorentz type of geometry.

6. The system according to any of the preceding claims, in which the second sensor (7) is a displacement sensor.

7. The system according to any of the preceding claims, in which the support unit (10) is controlled by a further control unit (15) in dependence on the first sensor (6) and the second sensor (7).

**Patentansprüche**

1. System zur Isolierung aktiver Vibrationen, umfassend eine Plattform (1), eine träge Bezugsmasse (4), eine Unterstützungseinheit (10) zur Unterstützung der Bezugsmasse (4) ohne mechanischen Kontakt, einen ersten Sensor (6) zur Bereitstellung eines Signals, das repräsentativ für den Abstand (dl) zwischen der Bezugsmasse (4) und der Plattform (1) ist, ein Betätigungselement (3) zum Verschieben der Plattform (1) in Bezug auf einen Lagerkörper (8), einen zweiten Sensor (7) zum Bereitstellen eines Signals, das repräsentativ für den Abstand (dl) zwischen der Plattform (1) und dem Lagerkörper (8) ist, und eine Steuereinheit (11) zum Steuern des Betätigungselements (3), wobei der erste Sensor (6) ein Verschiebungssensor ist, **dadurch gekennzeichnet, dass**

   - die Steuereinheit (11) geeignet ist, ein absolutes Rückführsignal vom ersten Sensor (6) und dem zweiten Sensor (7) zu empfangen, und geeignet ist, ein Signal für die Unterstützungseinheit (10) und das Betätigungselement (3) bereitzustellen,
   - und dass die Bezugsmasse (4) mit einer niedrigen, fast null betragenden Steifigkeit über die Unterstützungseinheit (10), die von der Plattform (1) unterstützt wird, mit der Plattform (1) verbunden ist.

2. System nach Anspruch 1, wobei die Unterstützungseinheit (10) eine Lorentz-Geometrie zur Unterstützung der Bezugsmasse (4) umfasst.

3. System nach Anspruch 1, wobei die Unterstützungseinheit (10) elektromagnetische, elektrostatische oder magnetostatische Mittel zur Unterstützung der Bezugsmasse (4) umfasst.

4. System nach einem der vorhergehenden Ansprüche, wobei der Abstand (dl) zwischen der Bezugsmasse und der Plattform durch optische, elektrische oder elektromagnetische Mittel gemessen wird.

5. System nach einem der vorhergehenden Ansprüche, wobei das Betätigungselement (3) eine Lorentz-Geometrie aufweist.

6. System nach einem der vorhergehenden Ansprüche, wobei der zweite Sensor (7) ein Verschiebungssensor ist.

7. System nach einem der vorhergehenden Ansprüche, wobei die Unterstützungseinheit (10) von einer weiteren Steuereinheit (15) in Abhängigkeit vom ersten Sensor (6) und vom zweiten Sensor (7) gesteuert wird.

**Revendications**

1. Système actif d'isolation des vibrations, comportant une plate-forme (1), une masse de référence inertielle (4), une unité de support (10) pour supporter la masse de référence (4) sans contact mécanique, un premier capteur (6) pour envoyer un signal qui est représentatif de la distance (dl) entre la masse de référence (4) et la plate-forme (1), un actionneur (3) pour déplacer la plate-forme (1) par rapport à un corps de roulement (8), un second capteur (7) pour envoyer un signal qui est représentatif de la distance (dl) entre la plate-forme (1) et le corps de roulement (8), et une unité de commande (11) pour commander l'actionneur (3), le premier capteur (6) étant un capteur de mouvement, **caractérisé en ce que**

    - l'unité de commande (11) est agencée pour recevoir un signal de mesure absolu depuis le premier capteur (6) et le second capteur (7), et est agencée pour fournir un signal à l'unité de support (10) et à l'actionneur (3), - et **en ce que** la masse de référence (4) est raccordée avec une faible rigidité, presque nulle, à la plate-forme (1) via l'unité de support (10) qui est supporté par la plate-forme (1).

2.   Système selon la revendication 1, dans lequel l'unité de support (10) présente une géométrie de type Lorentz supportant la masse de référence (4).

3.   Système selon la revendication 1, dans lequel l'unité de support (10) comporte un réseau de courant électromagnétique, électrostatique ou magnétostatique, pour supporter la masse de référence (4).

4.   Système selon l'une quelconque des revendications précédentes, dans lequel la distance (dl) entre la masse de référence et la plate-forme est mesurée par des moyens optiques, électriques ou électromagnétiques.

5.   Système selon l'une quelconque des revendications précédentes, dans lequel l'actionneur (3) présente une géométrie de type Lorentz.

6.   Système selon l'une quelconque des revendications précédentes, dans lequel le second capteur (7) et un capteur de mouvement.

7.   Système selon l'une quelconque des revendications précédentes, dans lequel l'unité de support (10) est commandée par une unité de commande supplémentaire (15) en fonction du premier capteur (6) et du second capteur (7).

Fig. 1

EP 2 235 394 B1

fig.2

fig.3

Fig. 4

fig. 5

fig. 6

sensor 6

**Pre-amplifier Anti-aliasing filter AD conversion** — $z_{s,m}$ →

**Controller**

(may consist of multichannel controller that couples $V_s$ and $V_p$ both to $z_{s,m}$ and $z_{p,m}$, as well as a compensation for the actuator (voice-coil) nonlinearities), c.f. the realization form in Fig. 8)

**DA-conversion Reconstruction filtering** — $V_s$ → **Voltage to current conv. $K_{s,i}$**

DC current. $i_{s,o}$

support unit 10

sensor 7

**Pre-amplifier Anti-aliasing filter AD conversion** — $z_{p,m}$ →

**DA-conversion Reconstruction filtering** — $V_p$ → **Voltage to current conv. $K_{p,i}$** — actuator 3

Fig. 4

Fig. 8

EP 2 235 394 B1

Fig. 9

EP 2 235 394 B1

fig. 10

fig. 11

Fig.12

22

fig.13

Fig. 14

**EP 2 235 394 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2005024266 A1
- US 6808051 B2
- WO 2004029475 A1
- WO 2004029475 A

**Non-patent literature cited in the description**

- **P.R. SAULSON.** Vibration isolation for broadband gravitational wave antennas. *Rev. Sci. Instrum.,* August 1984, vol. 55 (8), 1315-1320
- **P.G. NELSON.** An active vibration isolation system for inertial reference and precision measurement. *Rev. Sci. Instrum.,* September 1991, vol. 62 (9), 2069-2075